**Europäisches Patentamt**

(19) **European Patent Office**

**Office européen des brevets**

(11) Publication number: **0 081 642**
**B1**

(12) **EUROPEAN PATENT SPECIFICATION**

(45) Date of publication of patent specification: **16.08.90**

(21) Application number: **82109164.2**

(22) Date of filing: **04.10.82**

(51) Int. Cl.⁵: **H 01 L 29/743, H 01 L 29/60**

(54) **Multicellular thyristor.**

(30) Priority: **16.12.81 US 331049**
**24.06.82 US 391620**

(43) Date of publication of application:
**22.06.83 Bulletin 83/25**

(45) Publication of the grant of the patent:
**16.08.90 Bulletin 90/33**

(84) Designated Contracting States:
**CH DE FR GB LI SE**

(56) References cited:
**EP-A-0 028 797**
**EP-A-0 030 274**
**EP-A-0 039 943**
**DE-A-2 625 917**

(73) Proprietor: **GENERAL ELECTRIC COMPANY**
**1 River Road**
**Schenectady New York 12305 (US)**

(72) Inventor: **Temple, Victor Albert Keith**
**Main Street**
**Clifton Park New York 12065 (US)**

(74) Representative: **Kinne, Reinhard, Dipl.-Ing. et al**
**Patentanwaltsbüro Tiedtke-Bühling-Kinne-**
**Grupe-Pellmann-Grams-Struif Bavariaring 4**
**D-8000 München 2 (DE)**

Courier Press, Leamington Spa, England.

## Description

The invention relates to a multicellular thyristor according to the preamble of claim 1.

According to the features indicated in the preamble of claim 1 the present invention is proceeding from a prior art as it is known from EP—A—0 028 797 which document is disclosing a multicellular thyristor with an integral field-effect-transistor turn-off structure.

In DE—A—2 625 917 there is disclosed a multicellular thyristor with turn-off regions. The turn-off regions are not embedded in the respective emitter region but are disposed laterally spaced from the emitter regions.

The wafer of semiconductor material of the thyristor according to EP—A—0 028 797 includes an upper and a lower emitter layer being separated from each other by an upper and a lower base layer wherein a plurality of substantially identical cells is formed in these upper and/or lower base-emitter layers by A) forming the upper resp. lower emitter layer as a plurality of regions being embedded in the upper resp. lower base layer, and by B) embedding in each of the these upper resp. lower emitter regions an upper resp. lower turn-off region which has the same conductivity type as the upper resp. lower base layer, thereby forming a FET turn-off structure. In addition, there are provided as first electrode which is electrically connected to the upper emitter layer resp. to each of the upper emitter and turn-off regions and a second electrode which is electrically connected to the lower emitter layer resp. to each of the lower emitter and turn-off regions. Finally there is provided a plurality of gate electrodes, of which each one is insulatively covering a part of an associated upper resp. lower emitter region and a part of the base layer beneath this emitter region. That is why this thyristor in the following is referred to as being a "MOSTOT" (metal-oxide-semiconductor-turn-off-thyristor).

In response to the applying of a negative voltage pulse to the gate electrodes of the turn-off structure there is formed an inversion channel in the emitter regions below the associated gate electrode, by means of which the base layer and the turn-off regions are shortened. Due to this shortening a bypass carrier current is flowing which, in turn, is turning off the thyristor.

The proper value of the aforementioned bypass carrier current is crucial for obtaining a correct and constantly reproducible turn-off behaviour of the thyristor.

Accordingly, it is the object of the invention to improve a multicellular thyristor according to the preamble of claim 1.

According to the present invention this object is achieved by the advantageous measures indicated in the characterizing portion of claim 1.

Hence, according to the present invention, that parts of the upper resp. lower emitter regions which are insulatively covered by an associated gate electrode are fabricated such that they have a doping concentration which is lower than the doping concentration of the remainder of these emitter regions. It has been found that by carefully selecting the relationship of these two doping concentration values it is possible to obtain a constant and easily reproducible value of the bypass carrier current.

The invention is further described in conjunction with the accompanying drawing figures in which:

Figure 1 is a schematic, cross-sectional view of a portion of a MOSTOT incorporating one embodiment of the present invention;

Figure 2 is a composite graph of various parameters of the MOSTOT of Figure 1 versus the resistance of a bypass current path of such device;

Figure 3 is an electrical circuit representation of a portion of the MOSTOT shown in Figure 1;

Figure 4 is a schematic, cross-sectional view of a portion of a MOSTOT incorporating a further embodiment of the present invention;

Figure 5 is an electrical circuit representation of a portion of the MOSTOT shown in Figure 4;

Figure 6 is a schematic, cross-sectional view of a portion of a MOSTOT incorporating a still further embodiment of the present invention;

Figure 7 is an electrical circuit representation of a portion of the MOSTOT shown in Figure 6;

Figure 8 is a schematic, cross-sectional view of a portion of a MOSTOT incorporating a modification of the embodiment shown in Figure 6; and

Figure 9 is a schematic, cross-sectional view, in perspective, illustrating various aspects of a preferred implementation of the present invention.

Detailed description of the invention

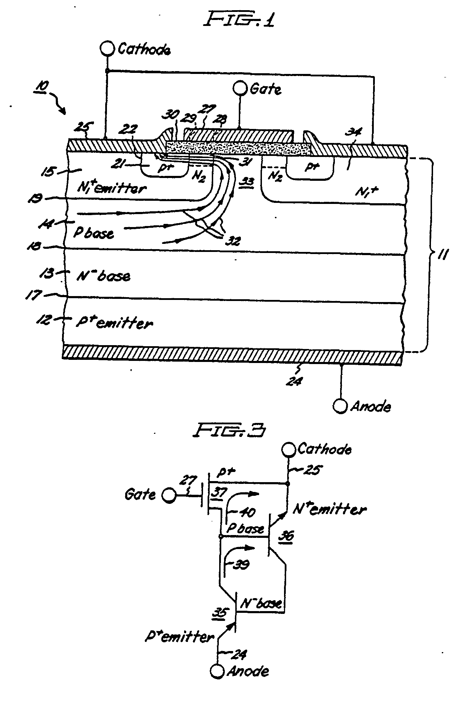

Figure 1 shows a portion of a MOSTOT 10. The left-hand side of said MOSTOT 10, as shown, comprises half of a cell the other side of which is preferably symmetrical with the shown half, and the right-hand side of said MOSTOT 10, as shown, comprises a portion of a further cell which advantageously is configured substantially the same as the former cell. Accordingly, only the left-hand cell is described in detail here.

Said MOSTOT 10 includes a wafer of semiconductor material 11 which comprises an upper 15 and a lower emitter layer 12 being separated from each other by an upper 14 and a lower layer 13. Said lower emitter layer 12 is separated from said upper layers 14 and 15 by said lower base layer 13; and said upper emitter layer 15 is separated from said lower layers 12 and 13 by said upper base layer 14. The junction between said lower layers 12 and 13 defines a first junction 17; the junction between said base layers 13 and 14 defines a second junction 18; and the junction between said upper layers 14 and 15 defines a third junction 19. Said lower emitter layer 12 and said upper base layer 14 are both of one conductivity type, P-type here; and said lower base layer 13 and said upper emitter layer 15 are both of the opposite conductivity type, N-type here. In the particular MOSTOT shown, said layers 12—15 comprise, respectively, a $P^+$ emitter region, an $N^-$ base region, a P base region, and an $N^+$ emitter region (having portions $N_1^+$ and $N_2$, as discussed below). Said lower emitter layer 12 preferably has a maximum doping concentration in excess of about $10^{18}$ impurity atoms per cubic centimeter; said lower base layer 13 preferably has a maximum doping concentration below about $10^{16}$ impurity atoms per cubic centimeter; said upper base layer 14 preferably has a maximum doping concentration below about $10^{17}$ impurity atoms per cubic centimeter; and the $N_1^+$ portion of said upper emitter layer 15 preferably has a maximum doping concentration in excess of about $10^{18}$ impurity atoms per cubic centimeter. It is desirable that the foregoing doping concentrations be selected to provide good thyristor action said MOSTOT 10, and, accordingly, specific quantitative values of such doping concentrations will be apparent to those skilled in the art.

Said wafer 11 further comprises an upper turn-off region 21 which adjoins said upper emitter layer 15 and is separated from said further layers 12—14 by said upper emitter layer 15. Said upper turn-off region 21 is of said one conductivity type, P-type here, and preferably has a doping concentration in excess of about $10^{18}$ impurity atoms per cubic centimeter to attain good electrical contact to first electrode 25, discussed below. The junction between said upper emitter layer 15 and said upper turn-off region 21 defines a fourth junction 22. Said third and fourth junctions 19 and 22 each have respective terminated portions at the exterior of said wafer 11, such terminated portions being at the upper surface of said wafer 11 in the particular embodiment shown.

A second electrode 24 is electrically connected to said lower emitter layer 12, and functions as an anode in said MOSTOT 10. A first electrode 25 is electrically connected to both said upper emitter layer 15 and said upper turn-off region 21, and functions as a cathode in said MOSTOT 10. A third electrode 27 is spaced from said wafer 11 by an insulative layer 30. Said third electrode 27 functions as a turn-off control gate in said MOSTOT 10. Said third electrode 27 "overlies" an area of said wafer 11 extending at a minimum from a location proximate the aforesaid terminated portion of said third junction 19, such as at dashed lines 28, to a location proximate the aforesaid terminated portion of said fourth junction 22, such as at dashed lined 29. While said third electrode 27 preferably overlaps the exposed portions of said third and fourth junctions 19 and 22, as shown, a small amount of underlap is tolerable. What is crucial is that, in accordance with the invention, said third electrode 27, said insulative layer 30, and said upper emitter layer 15 are so constructed and arranged that an inversion channel 31, as delineated by a dashed line within said upper emitter layer 15 and which connects together said upper base layer 14 and said upper turn-off region 21, is formed beneath said third electrode 27 by applying a bias voltage thereto which has a polarity and a magnitude suitable to attract minority carriers of said upper emitter layer 15 into said channel 31. The overlapping of said third electrode 27 over the exposed portions of said third and fourth junctions 19 and 22 serves to enhance such attraction of minority carriers of said upper emitter layer 15 into said channel 31, and helps to ensure a path of low resistance to "bypass" carriers, or carriers having a same electrical sign as such minority carriers. The electrical resistance to such bypass carriers (holes, here) of said channel 31 (hereinafter, simply "resistance") varies according to the magnitude of the aforesaid bias voltage in a manner which will be apparent to those skilled in the art.

To implement the instant embodiment of the invention, with said inversion channel 31 present due to the application to said third electrode 27 of the aforesaid bias voltage, the maximum electrical resistance presented to bypass carriers along a distributed, bypass carrier current path 32, extending from the interior of said upper base layer 14, through said channel 31, and through said upper turn-off region 21, to said first electrode 25, constitutes a value selected to limit forward biasing of said third junction 19 as a result of bypass carrier current flow in said current path 32 to no more than about one-half of the energy bandgap voltage of the semiconductor material forming said third junction 19 (hereinafter, simply "energy bandgap voltage"). This enables said MOSTOT 10 to turn off, as will be more apparent from the discussion of device turn-off below.

Said distributed bypass carrier current path 32, which exists during device turn-off is to be distinguished from the hole and electron current paths which exist in the device in the on-state. Such on-state current paths are generally oriented straight up and down across said various junctions 17, 18 and 19, as viewed in Figure 1.

To facilitate the attainment of the proper value for the resistance of said distributed, bypass carrier current path 32, said upper emitter layer 15 has an $N_2$ portion, as shown in Figure 1, in which said first channel 31 is situated and which preferably has a maximum doping concentration below about $10^{17}$ impurity atoms per cubic centimeter in the area occupied by said channel 31. This facilitates the creation of said inversion channel 31 upon the application to said third electrode 27 of the aforesaid bias voltage. Such doping of the $N_2$ portion in said upper emitter layer 15 can be achieved by, first, providing an $N^+$ diffusion for the entire upper emitter layer 15 through a first diffusion window, and, second, providing a carefully selected $P^+$ lateral diffusion for said upper turn-off region 21 through a second diffusion window located within the first diffusion window, thereby forming the $N_2$ portion having a lower doping concentration than the original $N^+$ diffusion. Alternatively, said upper emitter layer 15 can be formed by one diffusion for the $N_1^+$ portion, and another diffusion for the $N_2$ portion, which overlaps the diffusion for the $N_1^+$ portion after which said $P^+$ upper turn-off region 21 can be diffused into said upper emitter layer through a diffusion window located within the same diffusion window used for diffusing the $N_2$ portion.

Additionally, to facilitate the attainment of the proper value for the resistance of said distributed, bypass carrier current path 32, the following design considerations should be taken into account. Reducing the overall length of said current path 32 by reducing the horizontal dimension of said upper emitter layer 15 as viewed in Figure 1 will desirably decrease the resistance of said current path 32. Further, the length of said channel 31 (that is, the dimension in the direction of current flow) can be minimized, and the width of said channel 31 (that is, the dimension normal to the direction of current flow) can be maximized, both of which desirably decrease the resistance of said current path 32. In connection with maximizing the width of said channel 31, the configuration of said upper emitter layer 15 of said MOSTOT 10 as viewed from above (which defines the cell configuration) preferably is square or round, as opposed to being elongated, whereby the channel width per area of each cell is maximized. Still further, the doping of said upper base layer 14 and said upper turn-off region 21 to high concentrations desirably decreases the resistance of said current path 32; however, said upper base layer 14 should not be too highly doped lest the forward drop of said MOSTOT 10 becomes undesirably excessive.

In general, the lower the resistance of said bypass carrier current path 32, the greater the amount of device current that can be turned off. In a worst case analysis, said MOSTOT 10 could turn off a maximum amount of current equalling one-half of the energy bandgap voltage divided by the resistance of said current path 32. Such a worst case analysis assumes the following: (1) that *all* hole current passing upward in said MOSTOT 10 through said second junction 18 as viewed in Figure 1 is constrained to flow in said distributed current path 32; (2) that the total device current passing across said second junction 18 consists solely of hole current; and (3) that the maximum voltage across said third junction 19 must be reduced all the way to one-half of the energy bandgap voltage before device turn-off can occur. A computed example of a one-dimensional model of a particular implementation of said MOSTOT 10 of Figure 1 indicates, however, that said MOSTOT 10 can turn off considerably more current than in the foregoing, worst case.

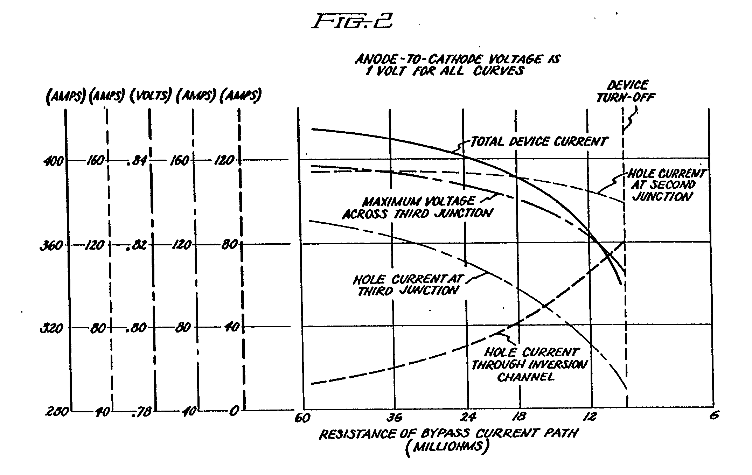

Such computed example has provided the data illustrated in the composite graph of Figure 2, wherein various device parameters are plotted against the resistance of said bypass carrier current path 32. When such resistance has been reduced to about 10 milliohms, said MOSTOT 10 turns off, and all the curves shown fall to zero. As can be appreciated from Figure 2, the hole current through the current path 32 ("Hole Current through Inversion Channel") comprises but a fraction of the hole current at said second junction 18. Additionally, it can be seen that the hole current in said current path 32 comprises only about 40 per cent of the total device current. Further, it can be seen that the maximum voltage across said third junction 19 only needs to be reduced to about 0.814 volts in order for turn-offs of said MOSTOT 10 to occur, as compared with one-half of the energy bandgap voltage, which is about 0.6 volts for silicon.

It is believed that the foregoing computed example represents more typical design assumptions than does the worst case, discussed above. Accordingly, a typical MOSTOT 10 of Figure 1 can turn off considerably more current than the worst case analysis suggests.

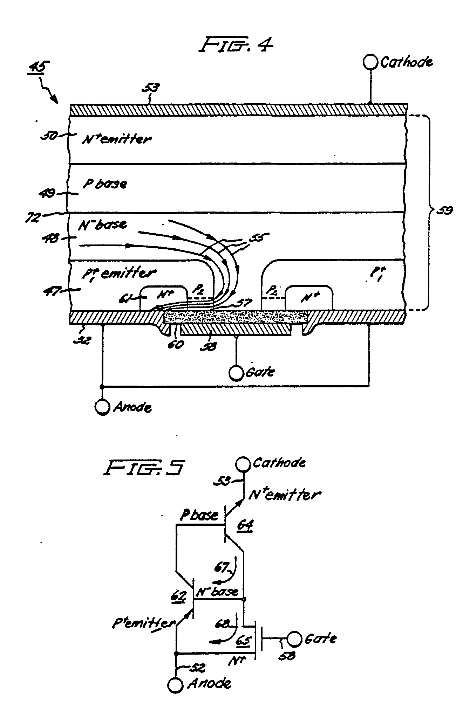

The operation of said MOSTOT 10 can be understood with reference to Figure 3, which shows an electrical circuit representation of one of the cells of said MOSTOT 10 of Figure 1. In Figure 3, the electrodes 24, 25 and 27 correspond to the like numbered electrodes in Figure 1. Said lower emitter layer 12 and said base layers 13 and 14 of Figure 1 are represented in Figure 3 by a bipolar transistor 35, while said base layers 13 and 14 and said upper emitter layer 15 are represented by a bipolar transistor 36. Said transistors 35 and 36 are coupled to each other on back-to-back fashion. Said inversion channel 31 of Figure 1, along with said $P^+$ upper turn-off region 21 at one end thereof and with said P upper base layer 14 at the other end thereof, is represented as a metal-oxide semiconductor field effect transistor ("MOSFET") 37 in Figure 3. When said MOSTOT 10 is in a turned on condition, device current flows from said anode electrode 24 to said cathode electrode 25, and said transistors 35 and 36 operate in a regenerative mode; that is, the collector current for one transistor drives the base of the other transistor, and vice-versa, thereby maintaining said MOSTOT 10 turned on. The hole current path from the collector of said transistor 35 to the base of said transistor 36 is indicated by a current arrow 39. Upon application of the aforesaid bias voltage (which is negative, here) to said gate electrode 27, said MOSFET 37 draws away or "steals" hole current from said hole current path 39, and directs the diverted current through the path indicated by a current arrow 40 (this is the analog of said bypass current path 32 of Figure 1), to said cathode electrode 25. When the bias voltage on said gate electrode 27 reaches a sufficient magnitude, the resistance through said MOSFET 37 will be sufficiently lowered to a value that reduces the base-to-emitter voltage of said transistor 36 below about one-half of the energy bandgap voltage of the semiconductor material forming its base-to-emitter junction. This causes said transistor 36 to turn off, which, in turn, causes said transistor 35 to turn off, thereby turning off the cell of said MOSTOT 10 of Figure 1, which is represented in Figure 3. For the entire MOSTOT 10 to turn off, however, it is necessary that all the cells in said MOSTOT 10 turn-off.

In order to achieve turn-off of said MOSTOT 10, said third electrode, or turn-off control gate 27, needs to be biased with a bias voltage and charged to a value proportional to the capacitance between said third electrode 27 and said wafer 11. Because the energy requirement for said turn-off control gate 27 is proportional to the product of the square of such bias voltage and the value of such capacitance, and because the values of both of such voltage and capacitance are low (for example, 10 volts and 1000 picofarads-$cm^2$, respectively), it can be appreciated that the energy requirement of said turn-off control gate 27 is likewise low.

When said MOSTOT 10 is operating in a turned on condition the region 33 between the vertical walls of said adjacent $N^+$ upper emitter layers 15 and 34 is a region of reduced electron injection from said $N^+$ upper emitter layers 15 and 34; accordingly, current flow from said anode 24 to said cathode 25 of said MOSTOT 10 is reduced in said region 33 compared with the remainder of the illustrated portion of said wafer 11. However, because said region 33 is typically much smaller than the remainder of said wafer 11, and because current spreading of electrons occurs as they flow downward to said anode 24, said MOSTOT 10 achieves utilization of a high percentage of said wafer 11 for carrying current therethrough. The deleterious effect of said region 33 becomes reduced as the dimension between said anode 24 and said cathode 25 becomes larger.

Turning now to Figure 4, a portion of a MOSTOT 45 incorporating a second embodiment of the invention is shown, and comprises two half cells in the same manner as said device 10 of Figure 1. Said MOSTOT 45 has four layers 47, 48, 49 and 50, respectively, which are suitably doped to the same concentrations as the four layers 12, 13, 14 and 15, respectively, of said MOSTOT 10 of Figure 1. Anode and cathode electrodes 52 and 53 of said MOSTOT 45 correspond to said anode and cathode electrodes 24 and 25 of said MOSTOT 10. In said MOSTOT 45, carriers, electrons here, are diverted to said anode electrode 52 through a distributed, bypass carrier current path 55, which is the complement of said bypass carrier current path 32 of said MOSTOT 10. Said current path 55 includes an inversion channel 57 within said lower emitter layer 47, which is the complement of said inversion channel 31 of said MOSTOT 10. Said inversion channel 57 is created by application of a bias voltage, positive here, to a turn-off control gate 58 which is separated from a wafer of semiconductor material 59 by an insulative layer 60. Said bypass carrier current path 55 further includes a lower turn-off region 61, which is the complement of said upper turn-off region 21 of said MOSTOT 10. Said gate electrode 58 and insulative layer 60 correspond to said gate electrode 27 and insulative layer 30 of said device 10. Additionally, said lower emitter layer 47 has a $P_1^+$ portion and a $P_2$ portion having a lower doping concentration than the $P_1^+$ portion, preferably corresponding to the preferred relative doping concentrations of the $N_1^+$ and $N_2$ portions, respectively, of said upper emitter layer 15 of said MOSTOT 10 discussed above. Accordingly, an understanding of said MOSTOT 45 will be apparent to those skilled in the art, based upon the above description of said MOSTOT 10, along with the foregoing comments noting complementarities and correspondences between said MOSTOT 10 and 45.

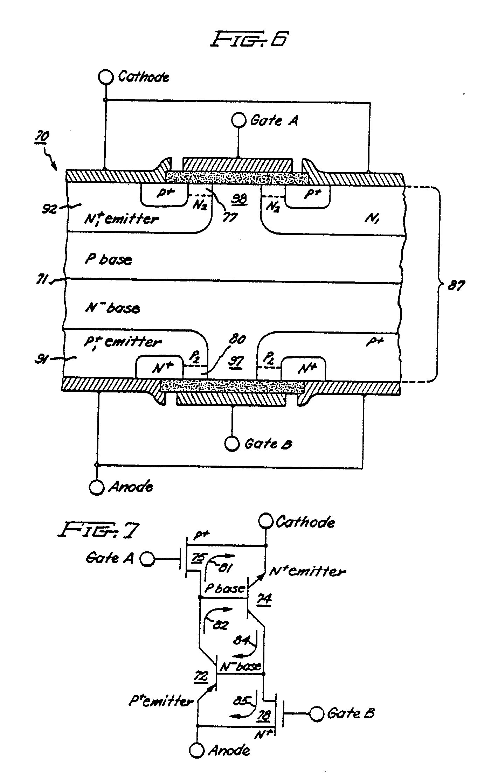

A further understanding of said MOSTOT 45 can be had fom considering its operation with reference to Figure 5, which shows an electrical circuit representation of one of the cells of said MOSTOT 45 of Figure 4. In Figure 5, electrodes 52, 53, 58 correspond to said like numbered electrodes in Figure 4. The four layers 47—50 are represented in Figure 5 by coupled, back-to-back bipolar transistors 62 and 64, in the same manner as said transistors 35 and 36 of Figure 3 represent the four layers 12—15 of said MOSTOT 10. Said inversion channel 57 of Figure 4, along with the $N^+$ region 61 at one end thereof and with said lower $N^-$ layer 48 at the other end thereof, is represented as a MOSFET 65 in Figure 5. When said MOSTOT 45 is in a turned-on condition, the device current flows from said anode electrode 52 to said cathode electrode 53, and said transistors 62 and 64 operate in a regenerative mode; that is, the collector current of one transistor drives the base of the other transistor, and vice-versa, thereby maintaining said MOSTOT 45 turned on. The electron current path from the collector of said transistor 64 to the base of said transistor 62 is indicated by current arrow 67. Upon application of the aforesaid bias voltage (which is positive, here) to said gate electrode 58, said MOSFET 65 draws away or "steals" electron current from said current path 67 and directs the diverted electron current through the path indicated by current arrow 68, to said anode electrode 52. When the bias voltage on said gate 58 reaches a sufficient magnitude, the resistance of said MOSFET 65 will be sufficiently reduced to such a value that the base-to-emitter voltage of said transistor 62 is reduced to below about one-half of the energy bandgap voltage thereof. This causes said transistor 62 to turn-off, which in turn, causes said transistor 64 to turn-off, thereby turning off the cell of said MOSTOT 45 of Figure 4 which is represented by the circuit of Figure 5. For the entire MOSTOT 45 to turn-off, however, it is necessary that all the cells in said MOSTOT 45 turn off.

As is the case with the embodiment shown in Figure 1, the embodiment of Figure 4 attains the objects of a low energy requirement for said turn-off gate control electrode 58, and of utilization of a high percentage of said wafer 59 thereof for carrying current.

Turning to Figure 6, a portion of MOSTOT 70 incorporating a third embodiment of the present invention is shown, and comprises two half cells in the same manner as said MOSTOT 10 of Figure 1. Said MOSTOT 70 incorporates features of both said MOSTOT 10 of Figure 1 and said MOSTOT 45 of Figure 4. Specifically, the portion of said MOSTOT 70 above second junction 71 suitably is substantially identical to the portion of said MOSTOT 10 above the second junction 18 thereof; and the portion of said MOSTOT 70 below the second junction 71 suitably is substantially identical to the portion of said MOSTOT 45 below second junction 72 thereof. Accordingly, an understanding of said MOSTOT 70 can be had by consideration of the above discussions of said MOSTOTs 10 and 45 in light of the foregoing comments.

The portion of said MOSTOT 70 shown thus has two turn-off control gates, gate A and gate B, which provides faster device turn-off, as will become apparent from the discussion below.

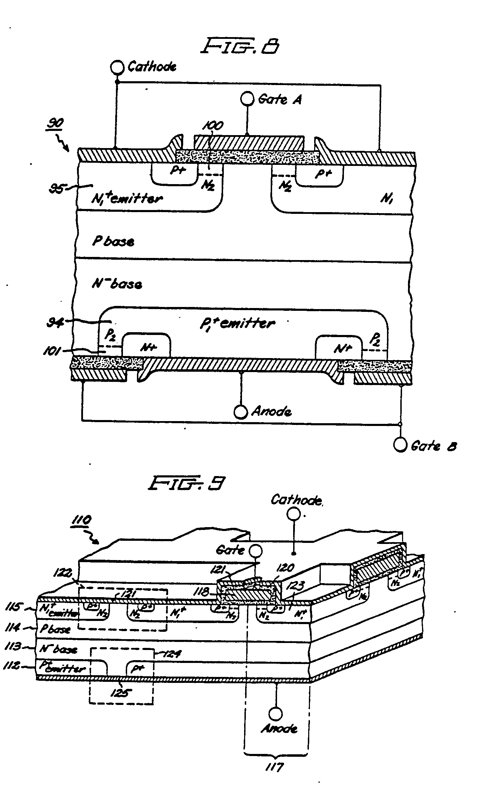

A further understanding of said MOSTOT 70, including details of operation, can be had by reference to Figure 7, which shows an electrical representation of one of the cells of said MOSTOT 70 shown of Figure 6.

In Figure 7, the gate A, gate B, anode and cathode electrodes correspond to the like electrodes of Figure 6. The four regions of the MOSTOT 70 of Figure 6, designated $P_1^+$ emitter, $N^-$ base, P base, and $N_1^+$ emitter, are represented in Figure 7 by bipolar transistors 72 and 74, in the same manner as said transistor 35 and 36 of Figure 3 represent the four layers 12—15 of said MOSTOT 10. An upper MOSFET 75 is associated with an upper inversion channel 77 of Figure 6, and a lower MOSFET 78 is associated with a lower inversion channel 80 of Figure 6. From the previous descriptions of said MOSTOTs 10 and 45, it can be appreciated that a negative bias voltage having a sufficient magnitude applied to gate A will divert sufficient hole current 81 away from the P base hole current 82 so as to reduce the base-to-emitter voltage of said transistor 74 below about one-half of the energy bandgap voltage thereof, thereby inducing turn-off said transistor 74. This, in turn, causes said transistor 72 to turn off; however, the turn-off of said transistor 72 is slowed by carrier recombination in said $N^-$ base region of said MOSTOT 70 after said second junction 71 becomes reverse biased during the process of device turn-off. In accordance with the instant embodiment of the present invention, the delay due to carrier recombination in said $N^-$ base region of said MOSTOT 70 is largely avoided by diverting sufficient electron current 85 away from the $N^-$ base electron current 84 and channelling said diverted electron current 85 to the anode electrode through said MOSFET 78, thereby turning off said transistor 72. Said MOSFET 78 is activated to accomplish this result through application to said gate B of a bias voltage, positive here, of sufficient magnitude so as to reduce the base-to-emitter voltage of said transistor 72 below about one-half of the energy bandgap voltage thereof. Accordingly, the instant embodiment of the invention attains the object of high-speed turn-off by not being subject to the entire delay of carrier recombination in its inner region, said $N^-$ base region here, after said second junction 71, or p-n junction between the two inner regions, P base and $N^-$ base, of said MOSTOT 70, becomes reverse biased.

In practising the foregoing described third embodiment of the invention, illustrated by way of example in Figure 6, the density of cells (which determine cell size or, alternatively, the number of cells when, for instance, some cells are deleted) of said MOSTOT 70 above said second junction 71 need not be the same as the density of cells below this junction. Further, in order to achieve the faster device turn-off, the aggregate hole current passing through all the inversion channels under gate A, such as said inversion channel 77, should be approximately equal to the aggregate electron current passing through all said inversion channels under gate B, such as said inversion channel 80, whereby the lower and upper bipolar transistor portions of said MOSTOT 70, represented by transistors 72 and 74 in Figure 7, respectively, turn off at approximately the same rate. This may require different cell densities above and below said second junction 71 in said MOSTOT 70, and, for example, where said wafer 87 of said MOSTOT 70 comprises silicon, the cell density above said second junction 71 should be greater than the cell density below this junction. This is because in silicon the resistance to hole current is greater than the resistance to electron current; thus, the cell density above said second junction 71, pertaining to bypass carrier current consisting of holes (not illustrated), should be relatively high, thereby shortening the path of such bypass carrier current (not illustrated) and limiting the resistance of such path to a desired value.

Said MOSTOT 70 additionally attains the objects of said previous MOSTOTS 10 and 45, namely, the objects of a low energy requirement for its turn-off control gates, (both gate A and gate B), and of the utilization of a high percentage of its semiconductor body 87 for carrying current.

Turning to Figure 8, a portion of a MOSTOT 90 illustrating a modification of said MOSTOT 70 of Figure 6 is shown. The difference between said MOSTOTs 70 and 90 is that in the MOSTOT 70, first and fourth regions 91 and 92, respectively, are horizontally aligned with each other as viewed in Figure 6, whereas in said device 90, first and fourth regions 94 and 95, respectively, are horizontally offset from each other as viewed in Figure 8. Said MOSTOT 70 of Figure 6 has the advantage of maximizing current-carrying capacity. This is because the areas of reduced carrier injections 97 and 98, adjacent to said first and fourth regions 91 and 92, (and thus, adjacent to said upper and lower inversion channels 77 and 80) are horizontally aligned with each other, thereby minimizing the influence of these regions in decreasing the current carrying capacity of said MOSTOT 70. On the other hand, said MOSTOT 90 of Figure 8 mazimizes turn-off speed. This is because the upper inversion channels, such as channel 100, which are horizontally offset from the lower inversion channels, such as channel 101, are provided with a large flow of hole current originating from a first layer 94; and the lower inversion channels, such as channel 101, are provided with a large flow of electron current originating from a fourth layer 95. With the foregoing inversion channels receiving large hole and electron currents, respectively, the lower and upper transistor portions of said MOSTOT 90, represented by said transistors 72 and 74 in Figure 7, respectively, are forced to turn off especially rapidly. The thicker said MOSTOTs 70 and 90 are, however, the less pronounced are the foregoing differences between them.

In making the MOSTOTs described herein, the first through third layers, as these terms are used above, are preferably fabricated using conventional techniques for making thyristors. This is due to the fact that the first and second junctions, as these terms are used above, comprise the main voltage blocking junctions of the respective MOSTOTs, at least where the four layers are doped to the various concentrations described herein, and also because thyristor technology comprehends the effectiveness of these junctions for voltage blocking purposes. Further, unlike the situation in MOS technology, carrier lifetime should be long, especially in the lower base region, so as to provide low forward voltage, as is known in the art. The turn-off gates and their associated insulative layers, as well as the turn-off region, as these terms are used above, are suitably fabricated using conventional techniques for making field-effect transistors ("FET's"). The upper emitter layer, as this term is used above, is suitably fabricated using either thyristor or FET technology.

Various aspects of a preferred implementation of the invention are illustrated in Figure 9, showing a portion of a MOSTOT 110. The semiconductor body of said MOSTOT 110 comprises a silicon wafer, with four layers 112—115, respectively, each comprising a layer substantially aligned with a major surface of the wafer. An area 117 of said MOSTOT 110 corresponds to the right-hand side of said MOSTOT 10 as shown in Figure 1. The shape of a cell in said MOSTOT 110 is square, and each cell is so constructed and arranged that approximately the same amount of device current is turned off by each. Turn-off gate electrode 118 comprises polysilicon, either P-type of N-type, which is doped to a very high concentration to increase its conductivity and to enable all cells with which said electrode 118 is associated to turn off at approximately the same time. Said gate electrode 118 has a substantially rectangular cross-section, and an insulative layer 120 forms a sleeve around the bottom, top, and sides thereof. Said insulative layer 120 comprises an oxide of the semiconductor body of said MOSTOT 110, deposited nitride, or a combination thereof. Cathode electrode 121 is disposed over the entire upper surface of the portion of said MOSTOT 110 shown, and is insulated from said gate electrode 118 by said insulative layer 120.

In area 122 of said MOSTOT 110, a cathode-emitter short is illustrated. Said cathode electrode 121 is disposed over the semiconductor body in the area 122, said gate electrode 118 advantageously not being present in this area because it does not interact with the semiconductor body in this area. Said cathode electrode 121 is connected to, and, thus, electrically shorts together portions of said N$^+$ emitter region 115 and said P base region 114, thereby reducing the sensitivity of said MOSTOT 110 to spurious turn-off due to noise or thermal currents in its semiconductor body. Said P$^+$ regions within the area 122, unlike the P$^+$ region within the fourth layer 123 of the area 117, do not perform any electrical function, but may conveniently be disposed there to simplify device manufacture. Cathode-emitter shorts preferably are occasionally but regularly interspersed amongst the cells in said MOSTOT 110 incorporating elements of the present invention, such as the cell in the area 117. This obviates the need for maintaining a bias voltage on said turn-off control gate 118 to keep said MOSTOT 110 in a turned-off condition. Alternatively, or in addition to the foregoing use of cathode-emitter shorts, anode-emitter shorts, such as the electrical short implemented in area 124 by anode electrode 125 connecting together the P$^+$ emitter region 112 and N$^-$ base region 113, preferably are occasionally but regularly interspersed amongst the cells in said MOSTOT 110 incorporating elements of the present invention, such as the cell in said area 117. Anode-emitter shorts, similar to cathode-emitter shorts, reduce the sensitivity of said MOSTOT 110 to spurious turn-on due to noise or thermal currents in its semiconductor body. Anode-emitter shorts also serve to speed up said MOSTOT 110 which with an anode-emitter short is what is known in the art as an asymmetric device, because it cannot block reverse voltage. Anode-emitter shorts per se, as well as cathode-emitter shorts per se, are known in the art.

While no specific gate means for turning on the various MOSTOTs described herein have been illustrated, it will be apparent to those skilled in the art that these MOSTOTs may suitably be turned on by any conventional gate means, such as by a turn-on gate electrode connected to one of the base layers, as these terms are used above, for turning on any of the MOSTOTs described herein. Additionally, these MOSTOTs can be turned on with an MOS turn-on gate, such as described in D. Kahng, editor, *Silicon Integrated Circuits - Part B,* Academic Press, 1981, at pages 265—267. A further suitable technique of turning on the MOSTOTs comprises optical light turn-on. Moreover, the invention renders practical turn-on of the MOSTOTs by noise of thermal current (or a combination thereof) in their semiconductor bodies, which heretofore has been characterized, for example, as "Non-Gated Undesirable Thyristor Triggering", the title of Chapter 6 of A. Blicher, *Thyristor Physics,* Springler-Verlag (1976). Such turn-on requires that a MOSTOT does not include cathode-emitter or anode-emitter shorts, such as described above, whereby the sensitivity of the MOSTOT to turn-on by noise or thermal current (or a combination thereof) is rendered high, and the MOSTOT will turn-on in a suitable environment, as will be apparent to those skilled in the art. Turn-off of the MOSTOT can then be enabled through use of the turn-off control gates described herein.

A MOSTOT in accordance with an alternative embodiment of the invention is structurally similar to any of the above-described devices; however, its distributed, bypass carrier current path (or paths) is designed with a resistance to bypass carriers that is too high to permit turn-off of the device solely be means of biasing the gate (or gates) of the device. Such device must be commutated off in similar manner as with a conventional thyristor; that is, the polarity of its anode-to-cathode voltage must be reversed so that the device turns off. However, such MOSTOT can turn off much more rapidly than a conventional thyristor. In addition, the design considerations discussed above that are useful in reducing the resistance of a distributed, bypass carrier current path can be relaxed. For example, the device can have a cell size which is larger than in the previously-described MOSTOTs, and, as such, could be fabricated with a higher yield.

While only certain preferred features of the invention have been shown by way of illustration, many modifications and changes will occur to those skilled in the art. For example, each of the lower base layers of the MOSTOTs described herein, which are shown as $N^-$ type, could be modified to have the portion thereof which is in contact with the respective lower emitter layer doped to a concentration substantially higher than the concentration of the remainder of the lower base layer, whereby the MOSTOT would become what is known in the art as an asymmetric device. As such it can be made thinner and still block the same forward voltage, provided that the resistance of the remainder of the lower base region is suitably increased. Such thinner devices are notably faster and have lower forward drops than do devices which lack the more highly doped portion in the lower base region. Since the foregoing asymmetric device cannot block reverse voltage, it preferably also incorporates anode-emitter shorts which similarly make the device asymmetric. Further, while the MOSTOTs described herein have been illustrated as formed by a planar diffusion process, other processes, involving the etching of a groove into a device semiconductor body, can just as well be used. Such a groove can have various shapes, depending upon whether a preferential etch or isotropic etch is used, and upon what the crystallographic orientation of the MOSTOT's semiconductor body is. Those skilled in the art will appreciate the range of possible groove shapes. By way of example, a common groove shape is that of a "V", as further described in D. Kahng, editor, *Silicon Integrated Circuits — Part B*, Academic Press, 1981, at pages 209—210. The invention does not depend upon the various regions of the described MOSTOTs having any particular configurations; therefore, other configurations of these regions can be utilized whereby, for example, a planar MOSTOT can be made having all of its p—n junctions terminating at a common MOSTOT surface which is planar. Further, referring to Figure 1, by way of example, the invention does not require the lower emitter layer 15 to have any particular shape; therefore, the lower emitter layer 15 could be elongated, or round, by way of example. Likewise, referring to Figure 4, by way of example, the present invention does not require the lower emitter layer 47 to have any particular shape; therefore, it could be elongated or round, by way of example. Still further, the invention applies to complementary devices, wherein P-type regions are used in place of the N-type regions described herein, and vice-versa. It is, therefore, to be understood that the appended claims are intended to cover all such modifications and changes as fall within the scope of the invention.

## Claims

1. Multicellular thyristor with an integral field-effect-transistor (FET) turn-off structure, said thyristor comprising:

[A] a wafer (11; 59; 87) of semiconductor material including

[A.1] an upper (15; 50; 92; 95; 115) and a lower emitter layer (12; 47; 91; 94; 112) being separated from each other by an upper (14; 49; 114) and a lower base layer (13; 48; 113), wherein

[A.2] a plurality of substantially identical cells is formed in said upper and/or lower base-emitter layers by

[A.2.1] forming said upper resp. lower emitter layer as a plurality of regions being embedded in said upper resp. lower base layer, wherein

[A.2.2] in each of said upper resp. lower emitter regions an upper (21) resp. lower (61) turn-off region is embedded which has the same conductivity type as said upper resp. lower base layer, thereby forming a FET turn-off structure;

[B] a first electrode (25; 53; 121) electrically connected to said upper emitter layer resp. to each of said upper emitter and turn-off regions;

[C] a second electrode (24; 52; 125) electrically connected to said lower emitter layer resp. to each of said lower emitter and turn-off regions; and

[D] a plurality of gate electrodes (27; 58; 118; A; B), each one insulatively (30; 60) covering a part of an associated upper resp. lower emitter region (31; 77; 100; 57; 80; 101) and a part of the base layer beneath said emitter region;

characterized in that said part of said upper resp. lower emitter regions which is insulatively covered by an associated gate electrode (27; 58; A; B) has a doping concentration ($N_2$) which is lower than the doping concentration ($N_1^+$) of the remainder of said emitter regions.

2. Multicellular thyristor according to claim 1, characterized in that said lower doping concen-

tration ($N_2$) is maximally below about $10^{17}$ impurity atoms per cubic centimeter and that said remainder part of said emitter regions has a maximum doping concentration in excess of about $10^{18}$ impurity atoms per cubic centimeter.

3. Multicellular thyristor according to one of the preceding claims, characterized in that at least a part of said lower base layer (13; 48; 113) has a maximum doping concentration below about $10^{16}$ impurity atoms per cubic centimeter and that said upper base layer (14; 49; 114) has a maximum doping concentration below about $10^{17}$ impurity atoms per cubic centimeter.

4. Multicellular thyristor according to one of the preceding claims, characterized in that said layer emitter layer (12; 47; 91; 94; 112), said lower base layer (13; 48; 113), said upper base layer (14; 49; 114) and said upper emitter layer (15; 50; 92; 95; 115) each comprise a respective layer substantially parallel to a major surface of said wafer (11; 59; 87).

5. Multicellular thyristor according to one of the preceding claims, characterized in that said first (25; 53; 121) and second (24; 52; 125) electrodes are free of electrical connection to said lower (13; 48) and upper (14; 49) base layers, respectively.

6. Multicellular thyristor according to one of the preceding claims, characterized in that said wafer (11; 59; 87) of semiconductor material comprises silicon.

7. Multicellular thyristor according to one of the preceding claims, characterized in that a lower turn-off gate electrode (58; B) comprises polysilicon.

8. Multicellular thyristor according to one of the preceding claims, characterized in that an insulating layer forms a sleeve around said lower turn-off gate electrode (58; B).

9. Multicellular thyristor according to one of the preceding claims, characterized in that one conductivity type is P-type and an opposite conductivity type is N-type.

**Patentansprüche**

1. Vielzelliger Thyristor mit einer Integral-Feldeffekttransistor-(FET-)Abschaltstrukter, wobei der besagte Thyristor umfaßt:

[A] ein Wafer (11; 59; 87) aus Halbleitermaterial, das enthält

[A.1] eine obere (15; 50; 92; 95; 115) und eine untere Emitterschicht (12; 47; 91; 94; 112), die voneinander durch eine obere (14; 49; 114) une eine untere Basisschicht (13; 48; 113) getrennt sind, wobei

[A.2] eine Mehrzahl von im wesentlichen identischen Zellen in den genanntenoberen und/oder unteren Basis-Emitterschichten gebildet ist durch

[A.2.1] Ausbilden der erwähnten oberen bzw. unteren Emitterschicht als eine Mehrzahl von Bereichen, die in die genannte obere bzw. untere Basisschicht eingebettet werden, wobei

[A.2.2] in jedem der erwähnten oberen bzw. unteren Emitterbereiche ein oberer (21) bzw. unterer (61) Abschaltbereich eingebettet ist, der denselben Leitfähigkeitstyp hat wid die genannte obere bzw. untere Basisschicht, wodurch eine FET-Abschaltstrukter gebildet wird;

[B] eine erste Elektrode (25; 35; 121), die elektrisch mit der genannten oberen Emitterschicht bzw. mit jedem der erwähnten oberen Emitter- und Abschaltbereiche verbunden ist;

[C] eine zweite Elektrode (24; 52; 125), die elektrisch mit der genannten unteren Emitterschicht bzw. mit jedem der erwähnten unteren Emitter- und Abschaltbereiche verbunden ist; und

[D] eine Mehrzahl von Torelektroden (27; 58; 118; A; B), von denen jede isolierend (30; 60) einen Teil eines zugeordneten oberen bzw. unteren Emitterbereichs (31; 77; 100; 57; 80; 101) und einen Teil des Basisschicht unterhalb des besagten Emitterbereichs abdeckt;

dadurch gekennzeichnet, daß der erwähnte Teil der besagten oberen bzw. unteren Emitterbereiche, der isolierend durch eine zugeordnete Torelektrode (27; 58; A; B) abgedeckt ist, eine Dotierungskonzentration ($N_2$) hat, die niedriger ist als die Dotierungskonzentration ($N_1{}^+$) des Restes der besagten Emitterbereiche.

2. Vielzelliger Thyristor nach Anspruch 1, dadurch gekennzeichnet, daß die erwähnte niedrigere Dotierungskonzentration ($N_2$) maximal unter etwa $10^{17}$ Fremdatomen por Kubikzentimeter liegt und daß der restliche Teil der besagten Emitterbereiche eine maximale Dotierungskonzentration über etwa $10^{18}$ Fremdatomen pro Kubikzentimeter hat.

3. Vielzelliger Thyristor nach einem der vorhergehenden Ansprüche, dadurch gekennzeichnet, daß wenigstens ein Teil der genannten unteren Basisschicht (13; 48; 113) ein maximale Dotierungskonzentration unterhalb etwa $10^{16}$ Fremdatomen pro Kubikzentimeter hat und daß die genannte obere Basisschicht (14; 49; 114) eine maximale Dotierungskonzentration unter etwa $10^{17}$ Fremdatomen pro Kubikzentimeter hat.

4. Vielzelliger Thyristor nach einem der vorhergehenden Ansprüche, dadurch gekennzeichnet, daß die erwähnte untere Emitterschicht (12; 47; 91; 94; 112), die genannte untere Basisschicht (13; 48; 113), die genannte obere Basisschicht (14; 49; 114) und die erwähnte obere Emitterschicht (15; 50; 92; 95; 115) jeweils eine zugeordnete, im wesentlichen zu einer Hauptfläche des besagten Wafers (11; 59; 87) parallele Schicht unfassen.

5. Vielzelliger Thyristor nach einem der vorhergehenden Ansprüche, dadurch gekennzeichnet, daß die gennante erste (25; 53; 121) sowie zweite (24; 52; 125) Elektrode von einer elektrischen Verbindung mit der genannten unteren (13; 48) und oberen (14; 49) Basisschicht jeweils frei sind.

6. Vielzelliger Thyristor nach einem der vorhergehenden Ansprüche, dadurch gekennzeichnet, daß das besagte Wafer (11; 59; 87) aus Halbleitermaterial Silizium umfaßt.

7. Vielzelliger Thyristor nach einem der vorhergehenden Ansprüche, dadurch gekennzeichnet, daß eine untere Abschalt-Torelektrode (58; B) Polysilizium umfaßt.

8. Vielzelliger Thyristor nach einem der vorhergehenden Ansprüche, dadurch gekennzeichnet, daß ein Isolierschicht eine Manschette un die genannte untere Abschalt-Torelektrode (58; B) bildet.

9. Vielzelliger Thyristor nach einem der vorhergehenden Ansprüche, dadurch gekennzeichnet, daß der eine Leitfähigkeitstyp ein P-Typ und ein entgegengesetzter Leitfähigkeitstyp ein N-Typ ist.

**Revendications**

1. Thyristor multicellulaire comportant une structure de blocage, intégrée à transistor à effet de champ (FET), ce thyristor comprenant:

[A] une tranche (11; 59; 87) d'un matériau semiconducteur comprenant

[A.1] une couche d'émetteur supérieure (15; 50; 92; 95; 115) et une couche d'émetteur inférieure (12; 47; 91; 94; 112) qui sont mutuellement séparées par une couche de base supérieure (14; 49; 114) et par une couche de base inférieure (13; 48; 113), dans lequel

[A.2] un ensemble de cellules pratiquement identiques sont formées dans les couches de base-émetteur supérieures et/ou inférieures par

[A.2.1] la formation de la couche d'émetteur supérieure, respectivement inférieure, sous la forme d'un ensemble de régions qui sont incorporées dans la couche de base supérieure, respectivement inférieure, dans lequel

[A.2.2] une région de blocage supérieure (21), respectivement inférieure (61), est incorporée dans chacune des régions d'émetteur supérieure, respectivement inférieure, et cette région de blocage a le même type de conductivité que la couche de base supérieure, respectivement inférieure, pour former ainsi une structure de blocage à FET;

[B] un première électrode (25; 53; 121) connectée électriquement à la couche d'émetteur supérieure, respectivement à chacune des régions d'émetteur et de blocage supérieures;

[C] une seconde électrode (24; 52; 125) connectée électriquement à la couche d'émetteur inférieure, respectivement à chacune des régions d'émetteur et de blocage inférieures; et

[D] un ensemble d'électrodes de grille (27; 58; 118; A; B), chacune d'elles recouvrant avec interposition d'un isolant (30; 60) une partie de la région d'émetteur supérieure, respectivement inférieure, associée (31; 77; 57; 80; 101) et une partie de la couche de base qui se trouve au-dessous de la région d'émetteur;

caractérisé en ce que la partie des régions d'émetteur supérieures, respectivement inférieures, qui est recouverte par une électrode de grille associée (27; 58; A; B), avec interposition d'un isolant, a une concentration de dopage ($N_2$) qui est inférieure à la concentration de dopage ($N_1^+$) du reste des régions d'émetteur.

2. Thyristor multicellulaire selon la revendication 1, caractérisé en ce que la concentration de dopage inférieure ($N_2$) est au maximum inférieure à environ $10^{17}$ atomes d'impureté par centimètre cube, et en ce que la partie restante des régions d'émetteur a une concentration de dopage maximale qui dépasse environ $10^{18}$ atomes d'impureté par centimètre cube.

3. Thyristor multicellulaire selon l'une des revendications précédentes, caractérisé en ce qu'au moins une partie de la couche de base inférieure (13; 48; 113) a une concentration de dopage maximale qui est inférieure à environ $10^{16}$ atomes impureté par centimètre cube, et en ce que la couche de base supérieure (14; 49; 114) a une concentration de dopage maximale qui est inférieure à environ $10^{17}$ atomes d'impureté par centimètre cube.

4. Thyristor multicellulaire selon l'une des revendications prédédentes, caractérisé en ce que chaque couche parmi la couche d'émetteur inférieure (12; 47; 91; 94; 112), la couche de base inférieure (13; 48; 113), la couche de base supérieure (14; 49; 114) et la couche d'émetteur supérieure (15; 50; 92; 95; 115) est constituée par une couche respective pratiquement parallèle à une surface principale de la tranche (11; 59; 87).

5. Thyristor multicellulaire selon l'une des revendications précédentes, caractérisé en ce que les première (25; 53; 121) et seconde (24; 52; 125) électrodes ne comportent aucune connexion électrique respectivement avec les couches de base inférieure (13; 48; 113) et supérieure (14; 49; 114).

6. Thyristor multicellulaire selon l'une des revendications précédentes, caractérisé en ce que la tranche de matériau semiconducteur (11; 59; 87) consiste en silicium.

7. Thyristor multicellulaire selon l'une des revendications précédentes, caractérisé en ce qu'une électrode de grille de blocage inférieure (58; B) consiste en silicium polycristallin.

8. Thyristor multicellulaire selon l'une des revendications prédédentes, caractérisé en ce qu'une couche isolante forme une gaine autour de l'électrode de grille de blocage inférieure (58; B).

9. Thyristor multicellulaire selon l'une des revendications précédentes, caractérisé en ce qu'un type de conductivité est le type P et un type de conductivité opposé est le type N.

## FIG.1

## FIG.3

FIG.2

ANODE-TO-CATHODE VOLTAGE IS
1 VOLT FOR ALL CURVES

DEVICE
TURN-OFF

(AMPS) (AMPS) (VOLTS) (AMPS) (AMPS)

TOTAL DEVICE CURRENT

HOLE CURRENT
AT SECOND
JUNCTION

MAXIMUM VOLTAGE
ACROSS THIRD JUNCTION

HOLE CURRENT AT
THIRD JUNCTION

HOLE CURRENT
THROUGH INVERSION
CHANNEL

RESISTANCE OF BYPASS CURRENT PATH
(MILLIOHMS)

EP 0 081 642 B1

FIG. 4

FIG. 5

## FIG. 6

## FIG. 7

4

## FIG. 8

Cathode

Gate A

90

100

P+

N₂

N₂

P+

95

N₁⁺emitter

N₁

P base

N⁻base

94

P₁⁺emitter

101

P₂

N+

N+

P₂

Anode

Gate B

## FIG. 9

110

Cathode

Gate

122

121

120

123

118

115

N₁⁺emitter

N₂

N₂

N+

N₂

N+

114

P base

113

N⁻base

124

112

P₁⁺emitter

P+

125

Anode

117

5